# EUROPEAN PATENT APPLICATION

(11) **EP 2 413 664 A1**
(43) Date of publication of application: **01.02.2012**
(21) Application number: 10756143.3
(22) Date of filing: 24.03.2010
(51) Int. Cl.: H05B 33/10, H01L 51/50

(54) **ORGANIC ELECTROLUMINESCENT ELEMENT AND PROCESS FOR MANUFACTURING ORGANIC ELECTROLUMINESCENT ELEMENT**

(30) Priority: 27.03.2009 JP 2009080270
(71) Applicant: FUJIFILM Corporation, Tokyo 106-0031 (JP)
(72) Inventor: HAYASHI, Naoyuki, Ashigarakami-gun Kanagawa (JP)
(74) Representative: HOFFMANN EITLE
(86) International application number: PCT/JP2010/055136
(87) International publication number: WO 2010/110347

(57) **Abstract**

To provide a method for manufacturing an organic electroluminescence device with satisfactory durability and excellent efficiency and an organic electroluminescence device.

A method for manufacturing an organic electroluminescence device including an organic layer on a substrate, which includes a step of performing an immersion treatment of the organic layer in a solvent containing an azeotropic solvent for water and a step of drying the organic layer.

## Description

### TECHNICAL FIELD

The present invention relates to an organic electroluminescence device and a method for manufacturing an organic electroluminescence device.

### BACKGROUND ART

With respect to devices utilizing an organic material, studies regarding an organic electroluminescence device (hereinafter sometimes as "OLED"), a transistor utilizing an organic semiconductor, and the like are actively carried out. In particular, organic electroluminescence devices are expected to be developed for large-area full-color display devices of a solid emission type or illumination applications as an inexpensive large-area surface light source. In general, an organic electroluminescence device includes an organic layer including a light emitting layer and a pair of counter electrodes interposing the organic layer therebetween. When a voltage is impressed to such an organic electroluminescence device, an electron is injected from a cathode, and a hole is injected from an anode, respectively into the organic layer. The electron and the hole are recombined in the light emitting layer, and at the time when an energy level returns from a conduction band to a valence band, energy is released as light, thereby obtaining light emission.

In the manufacture of an organic electroluminescence device, as a method of forming a thin film that is an organic layer to be provided between a pair of electrodes, vacuum vapor deposition is carried out as a vapor deposition method; and a spin coating method, a printing method, an inkjet method or the like is carried out as a wet method.

Above all, when a wet method is adopted, it becomes possible to use an organic polymer compound which is difficult for film formation according to a dry process such as vapor deposition and the like, and in the case of being used for flexible displays or the like, the wet method is suitable from the standpoint of durability such as flexural resistance, film strength and the like, and especially preferable in the case of realizing a large area.

However, organic electroluminescence devices obtained by a wet method involved such a problem that they are inferior in light emission efficiency or device durability. As a cause of bringing about deterioration of the light emission efficiency or device durability, moisture and oxygen may be considered. Although an organic layer formed by the wet method is dried by means such as vacuum drying and the like, it is difficult to completely remove the moisture in the organic layer, and it may be considered that aggregation or crystallization of an organic EL layer is advanced due to the residual moisture, so that the device is deteriorated. Also, it may be considered that oxidation of the organic EL layer by oxygen causes the generation and growth of a so-called dark spot and deterioration in luminance with time.

Then, for the purpose of removing initial moisture and oxygen in the inside of an organic EL device stacked by a wet method, Patent Document 1 describes a method for manufacturing an organic EL device by using a coating liquid prepared in an inert gas having a few moisture content and a low oxygen concentration to obtain an organic thin film layer.

### DOCUMENTS IN BACKGROUND ART

### PATENT DOCUMENTS

Patent Document 1: JP-A-2004-55225

### SUMMARY OF THE INVENTION

### PROBLEMS TO BE SOLVED BY THE INVENTION

However, the method of Patent Document 1 was insufficient for satisfaction from the standpoints of durability and efficiency of the device.

A problem of the invention is to solve the foregoing conventional problems and achieve the following object.

That is, an object of the invention is to provide a method for manufacturing an organic electroluminescence device with satisfactory durability and excellent efficiency and an organic electroluminescence device.

### MEANS FOR SOLVING THE PROBLEMS

Under the foregoing circumstances, the present inventors made extensive and intensive investigations. As a result, they have obtained knowledge that the foregoing problems can be solved by a method for manufacturing an organic electroluminescence device including an organic layer on a substrate, which includes a step of performing an immersion treatment in a solvent containing an azeotropic solvent for water and a step of drying the organic layer, leading to accomplishment of the invention.

That is, means for solving the foregoing problems are as follows.
[1] A method for manufacturing an organic electroluminescence device including an organic layer on a substrate, which is characterized by including a step of performing an immersion treatment of the organic layer in a solvent containing an azeotropic solvent for water and a step of drying the organic layer.
[2] The method for manufacturing an organic electroluminescence device as set forth in [1], wherein the azeotropic solvent for water is at least one member selected from solvents having an azeotropic temperature with water of lower than 100 °C.
[3] The method for manufacturing an organic electroluminescence device as set forth in [1] or [2], wherein the azeotropic solvent for water is at least one member selected from isopropanol, n-propanol, ethyl alcohol, n-butanol, sec-butanol, isobutyl alcohol, 2-(2-ethoxyethoxy)ethanol, 2-(2-methoxyethoxy)ethanol, ethylene glycol diethyl ether, butyl cellosolve and methyl ethyl ketone.
[4] The method for manufacturing an organic electroluminescence device as set forth in any one of [1] to [3], wherein the solvent containing an azeotropic solvent for water contains a solvent having a vapor pressure of 1 hPa or less at a temperature of the solvent in the step of performing an immersion treatment.
[5] The method for manufacturing an organic electroluminescence device as set forth in [4], wherein the solvent having a vapor pressure of 1 hPa or less is at least one member selected from butyl cellosolve, 2-(2-ethoxyethoxy)ethanol, 2-(2-methoxyethoxy)ethanol, 2-(2-ethoxyethoxy)ethyl acetate, ethylene glycol diethyl ether, ethylene glycol, diethylene glycol and triethylene glycol.
[6] The method for manufacturing an organic electroluminescence device as set forth in any one of [1] to [5], wherein the step of performing drying is carried out under an air pressure lower than atmospheric pressure.
[7] The method for manufacturing an organic electroluminescence device as set forth in any one of [1] to [6], wherein the step of performing drying is carried out at 100 °C or higher.
[8] An organic electroluminescence device, which is characterized by being manufactured by the method for manufacturing an organic electroluminescence device as set forth above in any one of [1] to [7].

### EFFECT OF THE INVENTION

According to the invention, a problem to be solve d by the invention is to solve the foregoing conventional problems and achieve the following object.

According to the invention, it is possible to provide a method for manufacturing an organic electroluminescence device, which is capable of fabricating an organic electroluminescence device with satisfactory durability and excellent efficiency.

Also, the invention is able to provide an organic electroluminescence device with satisfactory durability and excellent efficiency.

### BRIEF DESCRIPTION OF DRAWING

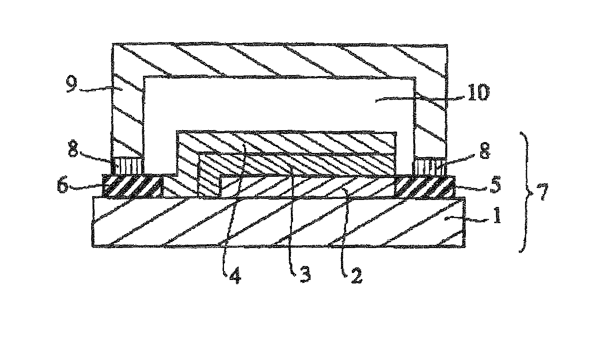

Fig. 1 is a diagrammatic sectional view showing one embodiment of a light emitting device of the invention

### MODES FOR CARRYING OUT THE INVENTION

The invention is hereunder described in detail. Incidentally, in this description, a numerical range expressed by the terms "a number to another number" means a range failing between the former number indicating a lower limit value of the range and the latter number indicating an upper limit value thereof.

### <Manufacturing method of organic electroluminescence device>

A manufacturing method of an organic electroluminescence device of the invention is described.

The manufacturing method of an organic electroluminescence device of the invention is a method for manufacturing an organic electroluminescence including an organic layer on a substrate and includes a step of performing an immersion treatment of a substrate having an organic layer formed thereon in a solvent containing an azeotropic solvent for water and a step of drying the organic layer.

### [Solvent containing an azeotropic solvent for water]

### (Azeotropic solvent for water)

The solvent which is used in the invention contains an azeotropic solvent for water. According to this, moisture in the organic layer formed on the substrate in the drying step can be thoroughly removed, thereby making it possible to prolong a life of the organic electroluminescence device.

The azeotropic solvent for water is preferably at least one member selected from solvents having an azeotropic temperature with water of lower than 100 °C. The azeotropic temperature with water is preferably from 98 to 50 °C, and more preferably from 80 to 50 °C. When the azeotropic temperature falls within this temperature range, the moisture in the organic layer can be more efficiently removed.

Such an azeotropic solvent for water is preferably at least one member selected from ethyl alcohol, n-propanol, isopropanol, n-butanol, sec-butanol, tert-butanol, isobutyl alcohol, 2-(2-ethoxyethoxy)ethanol, 2-(2-n-butoxyethoxy)ethanol, 2-(2-methoxyethoxy)ethanol, ethylene glycol diethyl ether, butyl cellosolve (2-n-butoxyethanol), propylene glycol monomethyl ether acetate, isopropyl ether, diisopropyl ether, methyl ethyl ketone, methyl propyl ketone, acetonitrile, butyronitrile, dimethyl carbonate, diethyl carbonate, cyclohexane, hexane, xylene, toluene, cumene, ethyl acetate, butyl acetate, isobutyl acetate, propyl acetate and isopropyl acetate; and more preferably at least one member selected from isopropanol, n-propanol, ethyl alcohol, n-butanol, sec-butanol, tert-butanol, isobutyl alcohol, 2-(2-ethoxyethoxy)ethanol, 2-(2-n-butoxyethoxy)ethanol, 2-(2-methoxyethoxy)ethanol, ethylene glycol diethyl ether, butyl cellosolve and methyl ethyl ketone, Alternatively, a halogen based hydrocarbon such as chloroform, dichloromethane, 1,2-dichloroethane, carbon tetrachloride, and the like may be used.

The azeotropic solvent for water may be a mixture of two or more kinds thereof. As a preferred combination in the case of mixing two or more kinds of azeotropic solvents for water, there can be exemplified combinations of at least one member selected from ethyl alcohol, n-propanol, isopropyl alcohol and methyl ethyl ketone and at least one member selected from butyl cellosolve and propylene glycol monomethyl ether acetate. A combination of isopropyl alcohol and butyl cellosolve is more preferable.

A content of the azeotropic solvent for water in the solvent containing an azeotropic solvent for water is preferably from 50 % by mass to 100 % by mass, and more preferably from 80 % by mass to 100 % by mass.

### (Other solvent)

In the case where the solvent containing an azeotropic solvent for water contains a solvent other than the azeotropic solvent for water, examples of other solvent include polyhydric alcohol based solvents and aprotic polar solvents.

As the polyhydric alcohol based solvent, there can be exemplified ethylene glycol, diethylene glycol, triethylene glycol, glycerin, and the like.

As the aprotic polar solvent, there can be exemplified N-methyl-2-pyrrlidone, 1,3-dimetlt.yl-2-imidazolidinane, dimethyl sulfoxide, propylene carbonate, γ-butyrolactone, dimethylacetamide, dimethylformamide, and the like.

### (Solvent having a vapor pressure of 1 hPa or less)

In the invention, it is preferable that the solvent containing an azeotropic solvent for water contains a solvent having a vapor pressure of 1 hPa or less at a temperature in the step of performing an immersion treatment.

The temperature in the step of performing an immersion treatment is preferably from 15 °C to 30 °C. A solvent having a vapor pressure of 1 hPa or less within this temperature range is useful. The vapor pressure is preferably not more than 0.8 hPa, and more preferably not more than 0.5 hPa. By using a solvent having a vapor pressure of 1 hPa or less, a drying rate of the solvent becomes slow, and drying unevenness can be suppressed; and such use is preferable from the standpoint of forming a smooth film.

Examples of the solvent having a vapor pressure of 1 hPa or less include ether based solvents and polyhydric alcohol based solvents.

As specific examples, there can be exemplified 2-(2-ethoxyetlioxy)ethanol, 2-(2-n-butoxyethoxy)ethanol, 2-(2-methoxyethoxy)ethanol, 2-(2-ethoxyetlioxy)ethyl acetate, butyl cellosolve, and the like.

Also, as the ether based solvent, there can be exemplified tetraethylene glycol dimethyl ether, ethylene glycol diethyl ether, and the like.

As the polyhydric alcohol based solvent, there can be exemplified ethylene glycol, diethylene glycol, triethylene glycol, glycerin, and the like.

The solvent having a vapor pressure of 1 hPa or less is preferably at least one member selected from butyl cellosolve, 2-(2-ethoxyethoxy)ethanol, 2-(2-n-butoxyethoxy)ethanol, 2-(2-methoxyethoxy)ethanol, 2-(2-etboxyethoxy)ethyl acetate, ethylene glycol diethyl ether, ethylene glycol, diethylene glycol and triethylene glycol.

The solvent having a vapor pressure of not more than 1 hPa may be a mixture of two or more kinds thereof.

As a preferred combination of the azeotropic solvent for water and the solvent having a vapor pressure of 1 hPa or less, it is preferable to use, as the azeotropic solvent for water, a solvent selected from alcohol solvents with a carbon number of from 2 to 4; and, as the solvent having a vapor pressure of 1 hPa or less, a solvent selected from ether based solvents.

A content of the solvent having a vapor pressure of 1 hPa or less in the solvent containing an azeotropic solvent for water is preferably from 90 % by mass to 10 % by mass, and more preferably from 80 % by mass to 20 % by mass.

Incidentally, each of the azeotropic solvent for water, the other solvent and the solvent having a vapor pressure of 1 hPa or less is preferably one having been subjected to a purification treatment. Specifically, there can be adopted an arbitrary method such as (1) a column purification treatment with a silica gel, alumina, a cationic ion exchange resin, an anionic ion exchange resin, etc.; (2) a dehydration treatment with anhydrous sodium sulfate, anhydrous calcium sulfate, magnesium sulfate, strontium sulfate, barium sulfate, barium oxide, calcium oxide, magnesium oxide, molecular sieves, zeolite, etc.; (3) a distillation treatment; (4) a bubbling treatment with an inert gas (e.g., nitrogen or argon), etc.; (4) a removal treatment of impurities by means of filtration, centrifugal sedimentation, etc.; and the like. A purification treatment by means of a column purification treatment or a dehydration treatment is more preferable.

### [Step of performing an immersion treatment]

The step of performing an immersion treatment as referred to herein means a step in which the organic layer is immersed in the solvent containing an azeotropic solvent for water, thereby leaving the organic layer from the solvent. A temperature at which the organic layer is immersed is preferably from 15 °C to 30 °C, and more preferably from 20 °C to 30 °C. This is because when the temperature falls within this temperature range, the temperature can be controlled by means of air conditioning of a clean room. Also, a time for performing immersion is preferably from 10 seconds to 10 minutes, and more preferably from 30 seconds to 3 minutes.

A method of immersing the organic layer in the solvent containing an azeotropic solvent for water is not particularly limited, and the organic layer may be left from the solvent containing an azeotropic solvent for water by immersing the organic layer by soaking it together with the substrate having the organic layer formed thereon in a tank in which the solvent containing an azeotropic solvent is charged and then lifting up it. Also, the organic layer may be left from the solvent containing an azeotropic solvent for water by pouring the solvent containing an azeotropic solvent for water into a vessel in which the substrate is charged, thereby immersing it and then discharging the solvent from the vessel.

After leaving the organic layer from the solvent containing an azeotropic solvent for water, it is preferable to remove the solvent on the organic layer by means of blowing with nitrogen or an air knife method with nitrogen. Adoption of an air knife method is more preferable. According to this, an excess of the solvent is removed, thereby enabling a drying time to be shortened.

From the viewpoint of more removing the moisture in a hole injection layer, it is preferable that the nitrogen to be used herein has a low dew point temperature. The dew point is more preferably -20 °C or less.

Although the organic layer to which the immersion treatment of the invention is applicable may be any layer obtained by film formation by means of a dry film forming method or a wet film forming method, the effect of the invention can be more exhibited by applying the immersion treatment to a film obtained by film formation by means of a wet film forming method.

Specifically, examples of the organic layer include a light emitting layer, a hole transport layer, a hole injection layer, a charge transport layer, a charge injection layer, and so on. The immersion treatment may be applied to any one of layers, or may be applied to plural layers. The immersion treatment is preferably applied to a hole injection layer or a hole transport layer, and more preferably applied to a hole injection layer.

According to the manufacturing method of an organic EL device of the invention, in view of the fact that the method includes a step of performing an immersion treatment of the organic layer in the solvent containing an azeotropic solvent for water and a step of drying the organic layer, an organic electroluminescence device with satisfactory durability and excellent light emission efficiency can be manufactured. It may be considered that this is because drying of the formed organic layer is thoroughly carried out, so that the removal of the moisture in the device can be thoroughly achieved.

In the case where plural organic layers are present, the foregoing step may be applied to at least one organic layer.

The organic layer may be film-formed by means of a dry film forming method or a wet film forming method. Adoption of a wet film forming method is preferable because a large area of the organic layer can be easily realized, and a light-emitting device with high luminance and excellent light emission efficiency is efficiently obtainable at low costs. A vapor deposition method, a sputtering method or the like can be adopted as the dry film forming method; and a printing method or a coating method can be adopted as the wet film forming method.

A first electrode may be a back electrode as described later, and as to a forming step of the first electrode, a description regarding a forming method of a back electrode can be applied.

A second electrode may be a transparent electrode as described later, and as to a forming step of the second electrode, a description regarding a forming method of a transparent electrode can be applied.

As a coating method in a step of forming an organic layer on a substrate having a first electrode formed thereon, a spin coating method, a dip coating method, a casting method, a die coating method, a roll coating method, a bar coating method, a gravure coating method, a spray coating method, an inkjet method, or the like can be adopted. Such a film forming method can be properly selected according to the material of the organic layer. Above all, a dip coating method, a spray coating method or an inkjet method is preferable because such a method is a method with high use efficiency of a coating liquid (with a few loss).

### [Step of drying]

Drying is performed by selecting a condition of temperature, pressure or the like in such a manner that the organic layer is not damaged. Also, at the time of drying, for the purposes of (1) preventing a lowering of light emission efficiency of the organic electroluminescence device following addition of oxygen to the organic layer from occurring and (2) preventing a lowering of durability of the organic electroluminescence device following moisture absorption of the organic layer from occurring, it is preferable to perform drying in an atmosphere of an inert gas with a low dew point (e.g., nitrogen, argon, etc.).

A temperature in the step of drying is preferably from 80 °C to 200 °C, more preferably 100 °C or higher, and still more preferably from 100 °C. to 150 °C.

It is preferable that the step of drying is carried out under an air pressure lower than atmospheric pressure. For example, the air pressure is preferably 100 kPa or less, and more preferably from 10 kPa to 0.1 kPa.

### [Organic electroluminescence device]

The organic electroluminescence device has an organic layer on a substrate.

It is preferable that the organic layer includes a light emitting layer; and that the light emitting layer contains a phosphorescent light emitting compound. If desired, an organic layer other than the light emitting layer, a protective layer, a sealing layer or the like may be provided.

It is preferable that the organic electroluminescence device is fabricated by the manufacturing method of the invention.

It is preferable that an oxygen concentration in the device is as low as possible. The oxygen concentration is sufficiently 100 ppm or less, and preferably 50 ppm or less. A method of obtaining an atmosphere where the oxygen concentration is 100 ppm or less is not particularly limited. For example, a sealing step may be carried out in an inert gas atmosphere where the oxygen concentration is 100 ppm or less. From the viewpoint of easiness of handling, the inert gas is preferably nitrogen, argon or the like.

Fig. 1 is a diagrammatic sectional view showing one embodiment of the light emitting device of the invention. The light emitting device shown in Fig. 1 includes a light emitting layered product 7 having a transparent electrode 2, an organic layer 3 and a back electrode 4 stacked on a base materials 1; and a sealing member 9 for sealing the organic layer 3. In such an embodiment, the sealing member 9 is allowed to adhere to the base material 1, a transparent electrode lead 5, a back electrode lead 6 and the like by a sealing agent (adhesive) 8 and placed on the light emitting layered product 7. A moisture absorbent or an inactive liquid may be inserted in a space 10. The moisture absorbent is not particularly limited, and specific examples thereof include barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieve, zeolite, magnesium oxide, and so on. Paraffins, liquid paraffins, fluorine based solvents (e.g., perfluoroalkanes, perfluoroamines, perfluoroethers, etc.), chlorine based solvents, silicone oils, and so on can be used as the inactive liquid.

In the light emitting device of the invention, the constitution of the light emitting layered product may be a constitution in which transparent electrode/light emitting layer/back electrode, transparent electrode/light emitting layer/electron transport layer/back electrode, transparent electrode/hole transport layer/light emitting layer/electron transport layer/back electrode, transparent electrode/hole transport layer/light emitting layer/back electrode, transparent electrode/light emitting layer/electron transport layer/electron injection layer/back electrode, transparent electrode/hole injection layer/hole transport layer/light emitting layer/electron transport layer/electron injection layer/back electrode, or the like are stacked successively or conversely on a base material, or the like. The light emitting layer contains a phosphorescent light emitting compound, and in general, light emission is extracted from the transparent electrode. Specific examples of compounds which are used in the respective layers are described in, for example, an extra issue "Organic EL Display" of *Monthly Display,* October, 1998 (Techno Times Co., Ltd.) and the like.

A position at which the organic layer is formed is not particularly limited and can be properly selected according to the application and purpose of the light emitting device. However, it is preferable that the organic layer is formed on the transparent electrode or back electrode. At that time, the organic layer may be formed on the entire surface or a part of the transparent electrode or back electrode. The shape, size and thickness of the organic layer can also be properly selected according to the purpose.

The organic layer(s) may be film-formed by properly selecting a dry film forming method or a wet film forming method. Adoption of a wet film forming method is preferable because a large area of the organic layer can be easily realized, and a light emitting device with high luminance and excellent light emission efficiency is efficiently obtainable at low costs. A vapor deposition method, a sputtering method or the like can be adopted as the dry film forming method; and a dipping method, a spin coating method, a dip coating method, a casting method, a die coating method, a roll coating method, a bar coating method, a gravure coating method, a spray coating method, an inkjet method, or the like can be adopted as the wet film forming method. Such a film forming method can be properly selected according to the material of the organic layer. In the case of achieving the film formation by means of a wet film forming method, drying may be carried out after the film formation. Drying is carried out by selecting a condition of temperature, pressure or the like in such a manner that the coating layer is not damaged.

The coating liquid which is used in the wet film forming method (coating process) includes in general a material of the organic layer and a solvent for dissolving or dispersing it therein. The solvent is not particularly limited, and it may be selected according to the material to be used in the organic layer. Specific examples of the solvent include halogen based solvents (e.g., chloroform, carbon tetrachloride, dichloromethane, 1,2-dichloroethane, chlorobenzene, etc.), ketone based solvents (e.g., acetone, methyl ethyl ketone, diethyl ketone, n-propyl methyl ketone, cyclohexanone, etc.), aromatic solvents (e.g., benzene, toluene, xylene, etc.), ester based solvents (e.g., ethyl acetate, n-propyl acetate, n-butyl acetate, methyl propionate, ethyl propionate, γ-butyrolactone, diethyl carbonate, etc.), ether based solvents (e.g., tetrahydrofuran, dioxane, etc.), amide based solvents (e.g., dimethylformamide, dimethylacetamide, etc.), dimethyl sulfoxide, water, and so on. Incidentally, a content of a solid matter relative to the solvent in the coating liquid is not particularly limited, and a viscosity of the coating liquid can also be arbitrarily selected according to the film forming method.

In general, when a direct current voltage (alternating current components may be contained) of from about 2 to 40 volts or a direct current is impressed between the transparent electrode and the back electrode, the light emitting device of the invention emits light. Also, in driving the light emitting device of the invention, driving methods described in JP-A-2-148687, JP-A-6-301355, JP-A-5-29080, JP-A-7-134558, JP-A-8-234685, JP-A-8-241047, U.S. Patents Nos. 5,828,429 and 6,023,308, Japanese Patent No. 2784615, and so on can be utilized. Although each of the layers constituting the light emitting layered product which is used in the invention is hereunder described in detail, it should not be construed that the invention is limited thereto.

### (A) Base material:

It is preferable that the base material which is used in the invention is made of a material which is impermeable to moisture, or a material which is extremely low in moisture permeability. It is preferable that the material does not scatter or attenuate light emitted from the organic layer. Specific examples thereof include inorganic materials such as zirconia-stabilized yttrium (YSZ), glass, and the like; organic materials such as polyesters, for example, polyethylene terephthalate, polybutylene terephthalate, polyethylene naphthalate, etc., polystyrene, polycarbonate, polyethersulfones, polyaiylates, allyl diglycol carbonate, polyimides, polycycloolefins, norbornene resins, poly(chlorotrifluoroethylene), and the like; and so on. Above all, organic materials not only having excellent heat resistance, dimensional stability, solvent resistance, electric insulating properties and processability but having low gas permeability and low hygroscopicity can be especially preferably used. The base material may be formed of a single material or may be formed of two or more kinds of materials. The material of the base material may be properly selected according to the material of the transparent electrode. For example, in the case where the transparent electrode is made of indium tin oxide (ITO), it is preferable to use a material having a small difference in lattice constant from ITO.

The shape, structure, size and the like of the base material can be properly selected according to the application and purpose of the light emitting device. As to the shape, a plate-shaped material is generally used. The structure may be a single-layer structure, or it may be a layered structure. Although the base material may be either colorless transparent or colored transparent, it is preferable that the base material is colorless transparent from the viewpoint that it does not scatter or attenuate light emitted from the light emitting layer.

A moisture permeation preventive layer (a gas barrier layer) may be provided on a surface of the base material on the electrode side, on a surface of the base material on the side opposite to the electrode, or on both of these two surfaces. As a material constituting the moisture permeation preventive layer, it is preferable to use an inorganic material such as silicon nitride, silicon oxide and the like. The moisture permeation preventive layer can be film-formed by means of a high-frequency sputtering method or the like. Also, if desired, a hard coat layer or an undercoat layer may be provided on the base material.

### (B) Transparent electrode:

In general, the transparent electrode has a function as an anode which supplies a hole to the organic layer. However, the transparent electrode can also be allowed to function as a cathode, and in that case, the back electrode is allowed to function as an anode. The case where the transparent electrode is allowed to work as an anode is hereunder described.

The shape, structure, size and the like of the transparent electrode are not particularly limited and can be properly selected according to the application and purpose of the light emitting device. As a material for forming the transparent electrode, metals, alloys, metal oxides, electrically conductive compounds and mixtures thereof, and so on can be used. Materials having a work function of 4 eV or more are preferably used. Specific examples thereof include antimony-doped tin oxide (ATO), fluorine-doped tin oxide (FTO), semiconductor metal oxides (e.g., tin oxide, zinc oxide, indium oxide, indium tin oxide (ITO), indium zinc oxide (IZO), etc.), metals (e.g., gold, silver, chromium, nickel, etc.), mixtures or layered products of such a metal and an electrically conductive metal oxide, inorganic electrically conductive substances (e.g.. copper iodide, copper sulfide, etc.), organic electrically conductive materials (e.g., polyaniline, polythiophene, polypyrrole, etc.) and layered products thereof with ITO, and so on.

The transparent electrode can be formed on the base material by means of a wet method such as a printing method, a coating method, and the like; a physical method such as a vacuum vapor deposition method, a sputtering method, an ion plating method, and the like; a chemical method such as CVD, a plasma CVD method, and the like; or the like. The forming method may be properly selected taking into consideration adaptability to the transparent electrode material. For example, in the case where ITO is used as the material of the transparent electrode, a direct current or high-frequency sputtering method, a vacuum vapor deposition method, an ion plating method, or the like may be adopted. Also, in the case where an organic electrically conductive material is used as the material of the transparent electrode, a wet film forming method may be adopted.

Patterning of the transparent electrode can be carried out by means of chemical etching by photolithography or the like, physical etching using a laser or the like, or the like. Also, the patterning may be carried out by vacuum vapor deposition or sputtering using a mask, a lift-off method, a printing method, or the like.

Although a position at which the transparent electrode is formed may be properly selected according to the application and purpose of the light emitting device, it is preferable to form the transparent electrode on the base material. At that time, the transparent electrode may be formed on the whole or only a part of the surface of the base material.

Although a thickness of the transparent electrode may be properly selected according to the material thereof, it is in general from 10 nm to 50 µm, and preferably from 50 nm to 20 µm. A resistance value of the transparent electrode is preferably not more than 10² Ω/square, and more preferably not more than 10 Ω/quare. The transparent electrode may be either colorless transparent or colored transparent. In order to extract light emission from the transparent electrode side, its permeability is regulated to preferably 60 % or more, and more preferably 70 % or more. The permeability can be measured in conformity with a known method using a spectrophotometer.

Also, electrodes described in detail in TOUMEI DODENMAKU NO SHINTENKAI (Novel Developments in Transparent Electrically Conductive Films) (edited by SAWADA, Yutaka, published by C.M.C. in 1999) or the like can be applied to the invention. In particular, in the case where a plastic base material with low heat resistance is used, it is preferable to use ITO or IZO as the transparent electrode material and to perform film formation at a low temperature of not higher than 150°C.

### (C) Back electrode:

In general, although the back electrode has a function as a cathode for injecting an electron into the organic layer, it can also be allowed to function as an anode. In that case, the transparent electrode is allowed to function as a cathode. The case where the back electrode is allowed to work as a cathode is hereunder described.

The shape, structure, size and the like of the back electrode are not particularly limited and can be properly selected according to the application and purpose of the light emitting device. As a material for forming the back electrode, metals, alloys, metal oxides, electrically conductive compounds and mixtures thereof, and so on can be used. Materials having a work function of not more than 4.5 eV are preferably used. Specific examples thereof include alkali metals (e.g., Li, Na, K, Cs, etc.), alkaline earth metals (e.g., Mg, Ca, etc.), gold, silver, lead, aluminum, a sodium-potassium alloy, a lithium-aluminum alloy, a magnesium-silver alloy, indium, rare earth metals (e.g., ytterbium, etc.), and so on. Although such a material may be used solely, it is preferable to jointly use two or more kinds thereof for the purpose of making both stability and electron injection properties compatible with each other. Of these materials, alkali metals and alkaline earth metals are preferable from the viewpoint of electron injection properties, and materials mainly including aluminum are preferable from the viewpoint of storage stability. The material mainly including aluminum as referred to herein means aluminum solely, an alloy or mixture of aluminum and from 0.01 to 10 % by mass of an alkali metal or an alkaline earth metal (e.g., a lithium-aluminum alloy, a magnesium-aluminum alloy, etc.). As the material of the back electrode, those described in detail in JP-A-2-15595, JP-A-5-121172, and so on can be used.

The back electrode can be formed by means of a wet method such as a printing method, a coating method, and the like; a physical method such as a vacuum vapor deposition method, a sputtering method, an ion plating method, and the like; a chemical method such as CVD, a plasma CVD method, and the like; or the like. The forming method may be properly selected taking into consideration adaptability to the back electrode material. For example, in the case of using two or more kinds of metals, or the like as the material of the back electrode, the back electrode can be formed by sputtering those materials simultaneously or successively.

Patterning of the back electrode can be carried out by means of chemical etching by photolithography or the like, physical etching using a laser or the like, or the like. Also, the patterning may be carried out by vacuum vapor deposition or sputtering using a mask, a lift-off method, a printing method, or the like.

Although a position at which the back electrode is formed may be properly selected according to the application and purpose of the light emitting device, it is preferable to form the back electrode on the organic layer. At that time, the back electrode may be formed on the whole or only a part of the surface of the organic layer. Also, a dielectric layer including a fluoride of an alkali metal or an alkaline earth metal, or the like may be disposed in a thickness of from 0.1 to 5 nm between the back electrode and the organic layer. The dielectric layer can be formed by means of a vacuum vapor deposition method, a sputtering method, an ion plating method, or the like.

Although a thickness of the back electrode may be properly selected according to the material thereof, it is in general from 10 nm to 5 µm, and preferably from 50 nm to 1 µm. The back electrode may be either transparent or opaque. The transparent back electrode may be formed by subjecting a layer of the foregoing materials to film formation thin in a thickness of from 1 to 10 µm and further laminating a transparent electrically conductive material such as ITO, IZO and the like thereon.

### (D) Light emitting layer:

In the light emitting device of the invention, it is preferable that the light emitting layer contains a phosphorescence light emitting compound. The phosphorescent light emitting compound which is used in the invention is not particularly limited so far as it is a compound capable of emitting light from a triplet exciton. As the phosphorescent light emitting compound, it is preferable to use an ortho-metalated complex or a porphyrin complex, and it is more preferable to use an ortho-metalated complex. Of the porphyrin complexes, a porphyrin platinum complex is preferable. The phosphorescent light emitting compound may be used sorely or in combination of two or more of kinds thereof.

The ortho-metalated complex as referred to in the invention is a generic name of a group of compounds described in YAMAMOTO, Akio, Organometallic Chemistry - Principles and Applications, pages 150 and 232, Shokabo Publishing Co., Ltd. (1982); H. Yersin, Photochemistry and Photophysics of Coordination Compounds, pages 71 to 77 and 135 to 146, Springer-Verlag (1987); and the like. Although a ligand for forming the ortho-metalated compound is not particularly limited, it is preferably a 2-phenylpyridine derivative, a 7,8-benzoquinoline derivative, a 2-(2-thienyl)pyridine derivative, a 2-(1-naphthyl)pyridine derivative or a 2-phenylquinolirte derivative. Such a derivative may have a substituent. Also, the derivative may have other ligand than the ligand which is essential for forming such an ortho-metalated complex. As a central metal for forming the ortho-metalated complex, any metal can be used so far as it is a transition metal. In the invention, rhodium, platinum, gold, iridium, ruthenium, palladium, or the like can be preferably used. Above all, iridium is especially preferable. The organic layer containing such an ortho-metalated complex has excellent light emission luminance and light emission efficiency. As to the ortho-metalated complex, specific examples thereof are also described in paragraphs [0152] to [0180] of Japanese Patent Application No. 2000-254171.

The ortho-metalated complex which is used in the invention can be synthesized according to known techniques such as those described in Inorg. Chem., 30, 1685, 1991; Inorg. Chem., 27, 3464, 1988; Inorg. Chem., 33, 545, 1994; Inorg. Chim. Acta, 181, 245, 1991; J. Organomet. Chem., 335, 293,1987; J. Am. Chem. Soc., 107, 1431, 1985; and so on.

Although a content of the phosphorescent light emitting compound in the light emitting layer is not particularly limited, it is, for example, from 0.1 to 70 % by mass, and preferably from 1 to 20 % by mass. When the content of the phosphorescent light emitting compound is 0.1 % by mass or more and 70 % by mass or less, the effect thereof can be sufficiently exhibited.

In the invention, the light emitting layer may contain a host compound, a hole transport material, an electron transport material, an electrically inactive polymer binder, or the like, if desired.

The host compound as referred to herein is a compound which causes energy transfer from an exited state thereof to the phosphorescent light emitting compound, resulting in causing light emission of the phosphorescent light emitting compound. Specific examples thereof include carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dirrgethylidene compounds, porphyrin compounds, anthraquinodimethane derivatives, anthrone derivatives, diphenylquinone derivatives, thiopyrane dioxide derivatives, carbodiimide derivatives, fluorenylidenemethane derivatives, distyrylpyrazine derivatives, heterocyclic tetracarboxylic acid anhydrides such as naphthalene perillene and the like, phthalocyanine derivatives, metal complexes of 8-quinolinol derivatives, metal complexes having, as a ligand, metal phthalocyanine, benzoxazole, benzothiazole, or the like, polysilane compounds, poly(N-vinylcarbazoie) derivatives, aniline copolymers, thiophene oligomers, electrically conductive polymers such as pnlythiophene and the like, polythiophene derivatives, polyphenylene derivatives, polyphenylene vinylene derivatives, polyfluorene derivatives, and so on. The host compound may be used solely or in combination of two or more kinds thereof.

The hole injection material and the hole transport material are not particularly limited so far as it has any one of a function to inject a hole from an anode, a function to transport a hole, and a function to block an electron injected from a cathode, and it may be either a low molecular material or a polymer material. Specific examples thereof include carbazole derivatives, triazole derivatives, oxazole derivatives, oxadiazole derivatives, imidazole derivatives. polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidene compounds, porphyrin compounds, polysilane compounds, poly(N-vinylcarbazole) derivatives, aniline copolymers, thiophene oligomers, electrically conductive polymers such as polythiophene and the like, polythiophene derivatives, polyphenylene derivatives, polyphenylene vinylene derivatives, polyfluorene derivatives, and so on. These may be used alone a two or more kinds thereof may be used. In the invention, it is preferable to use a PEDOT-PSS solution (polyethylene dioxy thiophene-polystyrene sulfonic acid doped material).

The electron transport material is not particularly limited so far as it has any one of a function to inject an electron from a cathode, a function to transport an electron, and a function to block a hole injected from an anode. For example, triazole derivatives, oxazole derivatives, oxadiazole derivatives, fluorenone derivatives, anthraquinodimethane derivatives, anthrone derivatives, diphenylquinone derivatives, thiopyrane dioxide derivatives, carbodiimide derivatives, fluorenylidenemethane derivatives, distyrylpyrazine derivatives, heterocyclic tetracarboxylic acid anhydrides such as naphthaleneperylene and the like, phthalocyanine derivatives, metal complexes of 8-quinolinol derivatives, metal complexes having, as a ligand, metallophthalocyanine, benzoxazole, benzothiazole, or the like, electrically conductive polymers such as aniline copolymers, thiophene oligomers, polythiophene, and the like, polythiophene derivatives, polyphenylene derivatives, polyphenylene vinylene derivatives, polyfluorene derivatives, and so on can be used.

As the polymer binder, polyvinyl chloride, polycarbonate, polystyrene, polymethyl methacrylate, polybutyl methacrylate, a polyester, polysulfone, polyphenylene oxide, polybutadiene, a hydrocarbon resin, a ketone resin, a phenoxy resin, a polyamide, ethyl cellulose, vinyl acetate, an ABS resin, polyurethane, a melamine resin, an unsaturated polyester compound, an alkyd resin, an epoxy resin, a silicone resin, polyvinyl butyral, polyvinyl acetal, and so on can be used. The light emitting layer containing a polymer binder can be easily formed in a large area upon coating by means of a wet film forming method.

A thickness of the light emitting layer is regulated to preferably from 10 to 200 nm, and more preferably from 20 to 80 nm. When the thickness is not more than 200 nm, an increase of the driving voltage can be inhibited, whereas when it is 10 nm or more, a short circuit of the light emitting device can be prevented from occurring.

### (E) Electron transport layer:

The light emitting device of the invention may have an electron transport layer including the foregoing electron transport material, if desired. The electron transport layer may contain the foregoing polymer binder. A thickness of the electron transport layer is preferably from 10 to 200 nm, and more preferably from 20 to 80 nm. When the thickness is not more than 200 nm, an increase of the driving voltage can be inhibited, whereas when it is 10 nm or more, a short circuit of the light emitting device can be prevented from occurring.

### (F) Hole injection layer and hole transport layer:

The light emitting device of the invention may have a hole injection layer or a hole transport layer containing the foregoing hole injection material or hole transport material, if desired. The hole injection layer and the hole transport layer may contain the foregoing polymer binder. A thickness of the hole injection layer and the hole transport layer is regulated to preferably from 10 to 200 nm, and more preferably from 20 to 80 nm. When the thickness is not more than 200 nm, an increase of the driving voltage can be inhibited, whereas when it is 10 nm or more, a short circuit of the light emitting device can be prevented from occurring.

### (G) Others:

The light emitting device of the invention may have a protective layer described in JP-A-7-85974, JP-A-7-192866, JP-A-8-222891, JP-A-10-275682, JP-A-10-106746, or the like. The protective layer is formed on the uppermost surface of the light emitting device. The uppermost surface as referred to herein means an outer surface of a back electrode in the case of stacking a base material, a transparent electrode, an organic layer and a back electrode in this order, whereas it means an outer surface of a transparent electrode in the case of stacking a base material, a back electrode, an organic layer and a transparent electrode in this order. The shape, size, thickness and the like of the protective layer are not particularly limited. A material constituting the protective layer is not particularly limited so far as it has a function to prevent penetration or permeation of a substance which may deteriorate the light emitting device, such as moisture, oxygen, and the like, into the device. Silicon oxide, silicon dioxide, germanium oxide, germanium dioxide, or the like can be used.

A method of forming the protective layer is not particularly limited, and for example, a vacuum vapor deposition method, a sputtering method, a reactive sputtering method, a molecular epitaxy method, a cluster-ion beam method, an ion plating method, a plasma polymerization method, a plasma CVD method, a laser CVD method, a thermal CVD method, a coating method, or the like can be adopted.

### [Sealing]

Also, it is preferable that a sealing layer for preventing penetration of moisture or oxygen is provided in the light emitting device. As a material for forming the sealing layer, copolymers of tetrafluoroethylene and at least one comonomer; fluorine-containing copolymers having a cyclic structure in a copolymer main chain thereof; polyethylene; polypropylene; polymethyl methacrylate; polyimides; polyurea; polytetrafluoroethylene; polychlorotrifluoroethylene; polydichlorodifluoroethylene; copolymers of chlorotrifluoroethylene or dichlorodifluoroethylene and other comonomer; water absorbing substances having a coefficient of water absorption of 1 % or more; moisture permeation preventive substances having a coefficient of water absorption of not more than 0.1 %; metals (e.g., In, Sn, Pb, Au, Cu, Ag, Al, Tl, Ni, etc.); metal oxides (e.g., MgO, SiO, Si0₂, Al₂0₃, GeO, NiO, CaO, BaO, Fe₂0₃, Y₂0₃, Ti0₂, etc.); metal fluorides (e.g., MgF₂, LiF, AlF₃, CaF₂, etc.); liquid fluorinated carbons (e.g., perfluoroalkanes, perfluoroamines, perfluoroethers, etc.); substances obtained by dispersing an adsorbing agent of moisture or oxygen in the liquid fluorinated carbon; and so on can be used.

According to the organic EL device of the invention, light emission can be obtained by impressing a direct current (alternating current components may be contained, if desired) voltage (usually from 2 volts to 15 volts) or a direct current between the anode and the cathode.

As to the driving method of the organic EL device of the invention, driving methods described in JP-A-2-148687, JP-A-6-301355, JP-A-5-29080, JP-A-7-134558, JP-A-8-234685, JP-A-8-241047, Japanese Patent No. 2784615, U.S. Patents Nos. 5,828,429 and 6,023,308, and so on can be applied.

### [Application]

The inorganic material of the invention can be suitably utilized as a device because when used as an electrode, it is able to give high efficiency and device life. In particular, when the inorganic material of the invention is used as an organic electroluminescence device, it is able to give high efficiency and device life, and therefore, it is suitably used for full-color displays, backlights, surface light sources such as illumination light sources and the like, light source arrays of printers or the like, and so on.

### EXAMPLES

The invention is more specifically described below with reference to the Examples. Materials, reagents, amounts of substances and ratios thereof, operations, and the like shown in the following Examples can be appropriately changed unless deviating from the gist of the invention. In consequence, it should be construed that the scope of the invention is not limited to the following specific examples.

### (Preparation of solvent containing an azeotropic solvent for water (solvent A))

Isopropanol (boiling point: 82.5 °C; an azeotropic solvent; azeotropic temperature with water: 80.1 °C) and butyl cellosolve (boiling point: 170.2 °C; an azeotropic solvent; azeotropic temperature with water: 79.2 °C; vapor pressure: 0.8 hPa (20 °C)) were mixed in a mass ratio of 80/20, thereby preparing a solvent A.

### [Example 1]

### (Fabrication of organic EL device)

A material obtained by subjecting ITO to vapor deposition and film formation in a thickness of 150 nm on a glass substrate of 25 mm × 25 mm × 0.7 mm was prepared as a transparent supporting substrate. This transparent supporting substrate was subjected to etching and washing.

A coating liquid obtained by adding 10 % by mass of isopropyl alcohol and 0.01 % by mass of Zonyl FSO-300 (manufactured by E.I. du Pont de Nemours and Company) to 89.9 % by mass of a PEDOT-PSS solution (polyethylene dioxy thiophene-polystyrene sulfonic acid doped material)/CLEVIOS P AI 4083 (manufactured by H.C. Sterck Inc.) was spin coated as a hole injection layer on this ITO glass substrate and then dried on a hot plate at 100 °C for 10 minutes, thereby film-forming a hole injection layer (film thickness: about 60 nm).

### (Immersion treatment)

The ITO substrate having a hole injection layer film-formed thereon was immersed in the solvent A for one minute, the substrate was lifted up, and the solvent on the film surface was then removed by means of blowing with nitrogen (dew point: -30 °C).

### (Drying)

The resultant was vacuum dried (at 10 kPa) at 150 °C for one hour, thereby obtaining a dehydrated hole injection layer.

NPD was vapor deposited in a film thickness of 20 nm thereon by means of a vacuum vapor deposition method, thereby preparing a hole transport layer. Subsequently, Ir(ppy)₃ as a light emitting material and CBP as a host material were subjected to vapor co-deposition in a mass ratio of the light emitting material to the host material of 5/95 in a thickness of 30 nm.

Subsequently, BAlq was vapor deposited in a film thickness of 40 nm thereon by means of a vacuum vapor deposition method, thereby preparing an electron injection layer.

Then, lithium fluoride was vapor deposited in a thickness of 1 nm thereon, and furthermore, metallic aluminum was vapor deposited in a thickness of 70 nm thereon, thereby preparing a cathode.

The fabricated layered product was placed in an argon gas-substituted glove box and sealed by using a stainless steel-made sealing can and an ultraviolet ray-curable adhesive (XNR5516HV, manufactured by Nagase-Ciba Ltd.).

### [Example 2]

### (Fabrication of organic EL, device)

A material obtained by subjecting ITO to vapor deposition and film formation in a thickness of 150 nm on a glass substrate of 25 mm × 25 mm × 0.7 mm was prepared as a transparent supporting substrate. This transparent supporting substrate was subjected to etching and washing.

A coating liquid obtained by adding 10 % by mass of ethanol to 90 % by mass of a PEDOT-PSS solution (polyethylene dioxy thiophene-polystyrene sulfonic acid doped material)/CLEVIOS P AI 4083 (manufactured by H.C. Sterck Inc.) was spin coated as a hole injection layer on this ITO glass substrate and then dried on a hot plate at 100 °C for 10 minutes, thereby film-forming a hole injection layer (film thickness: about 40 nm).

### (Immersion treatment)

The ITO substrate having a hole injection layer film-formed thereon was immersed in butyl cellosolve for one minute, the substrate was lifted up, and the solvent on the film surface was then removed by means of blowing with nitrogen (dew point: -30 °C)).

Drying of the substrate and fabrication of a layered product were carried out in the same manner as that in Example 1, thereby fabricating an organic EL Device.

### [Example 3]

### (Preparation of solvent containing an azeotropic solvent for water (solvent B))

Methyl ethyl ketone (boiling point: 79.5 °C; an azeotropic solvent; azeotropic temperature with water: 73.6 °C) and 2-(2-n-butoxyethoxy)ethanol (boiling point: 230.4 °C; an azeotropic solvent; azeotropic temperature with water: 99.8 °C; vapor pressure: 0.1 hPa (20 °C)) were mixed in a mass ratio of 20/80, thereby preparing a solvent B.

An organic EL device was fabricated in the same manner as that in Example 2, except for using the solvent B in place of the butyl cellosolve.

### [Comparative Example 1]

A comparative organic EL device was fabricated in the same manner as that in Example 1, except that the immersion treatment in Example 1 was not performed.

The compounds and the like used in the devices of the Examples and Comparative Example are shown below.

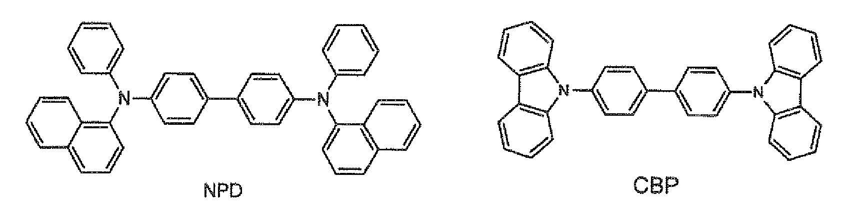

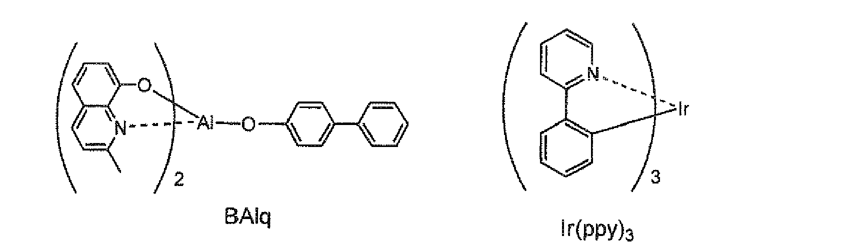

### (Performance evaluation)

### (1) Driving durability:

A constant current was impressed to the OLED device at an initial light emission luminance of 500 cd/m² and at room temperature (20 °C); driving was continuously performed; and a time until the light emission luminance dropped to 1/2 (luminance half time (h)) was measured.

### (2) External quantum efficiency.:

A light emission luminance at a driving current density of 2.5 mA/cm² was measured. As to a measurement method, a spectral radiance in the front of the organic EL device was measured using a spectral radiance meter (CS-1000, manufactured by Konica Minolta Holdings, Inc.), and an external quantum efficiency (%) was calculated.

### (Evaluation results)

The obtained results are shown in Table 1.

**Table 1**

| | Immersion treatment | Luminance half time (h) | External quantum efficiency (%) |
|---|---|---|---|
| Example 1 | Yes | 242 | 6.86 |
| Example 2 | Yes | 320 | 9.25 |
| Example 3 | Yes | 180 | 6.18 |
| Comparative Example 1 | No | 14.2 | 5.44 |

As a result of the evaluation, it is noted that the organic EL device of the invention has an extremely long luminance half time and excellent durability. Also, it was noted that the organic EL device of the invention has high external quantum efficiency and excellent efficiency.

### INDUSTRIAL APPLICABILITY

According to the invention, it is possible to provide a method for manufacturing an organic electroluminescence device, which is capable of fabricating an organic electroluminescence device with satisfactory durability and excellent efficiency.

Also, the invention is able to provide an organic electroluminescence device with satisfactory durability and excellent efficiency.

While the invention has been described in detail and with reference to specific embodiments thereof, it will be apparent to one skilled in the art that various changes and modifications can be made therein without departing from the spirit and scope thereof. This application is based on a Japanese patent application (No. 2009-080270) filed on March 27, 2009, the contents of which are incorporated herein by reference.

### DESCRIPTION OF LETTERS OR NUMERALS

- 1:: Base material
- 2:: Transparent electrode
- 3:: Organic layer
- 4:: Back electrode
- 5:: Transparent electrode lead
- 5:: Back electrode lead
- 7:: Light emitting layered product
- 8:: Sealing agent (adhesive)
- 9:: Sealing member
- 10:: Space

## Claims

1. A method for manufacturing an organic electroluminescence device including an organic layer on a substrate, which comprises: a step of performing an immersion treatment of the organic layer in a solvent containing an azeotropic solvent for water; and a step of drying the organic layer.

2. The method for manufacturing an organic electroluminescence device according to claim 1, wherein the azeotropic solvent for water is at least one member selected from solvents having an azeotropic temperature with water of lower than 100 °C.

3. The method for manufacturing an organic electroluminescence device according to claim 1 or 2, wherein the azeotropic solvent for water is at least one member selected from isopropanol, n-propanol, ethyl alcohol, n-butanol, sec-butanol, tert-butanol, isobutyl alcohol, 2-(2-n-butoxyethoxy)ethanol, 2-(2-ethoxyethoxy)ethanol, 2-(2-methoxyethoxy)ethanol, ethylene glycol diethyl ether, butyl cellosolve and methyl ethyl ketone.

4. The method for manufacturing an organic electroluminescence device according to any one of claims 1 to 3, wherein the solvent containing an azeotropic solvent for water contains a solvent having a vapor pressure of 1 hPa or less at a temperature of the solvent in the step of performing the immersion treatment.

5. The method for manufacturing an organic electroluminescence device according to claim 4, wherein the solvent having a vapor pressure of 1 hPa or less is at least one member selected from butyl cellosolve, 2-(2-ethoxyethoxy)etlzanol, 2-(2-n-butoxyethoxy)ethanol, 2-(2-rrcethoxyethoxy)ethanol, 2-(2-ethoxyethoxy)ethyl acetate, ethylene glycol diethyl ether, ethylene glycol, diethylene glycol and triethylene glycol.

6. The method for manufacturing an organic electroluminescence device according to any one of claims 1 to 5, wherein the step of drying is carried out under an air pressure lower than atmospheric pressure.

7. The method for manufacturing an organic electroluminescence device according to any one of claims 1 to 6, wherein the step of drying is carried out at 100 °C or higher.

8. An organic electroluminescence device manufactured by a method for manufacturing an organic electroluminescence device according to any one of claims 1 to 7.
